**Europäisches Patentamt**

**European Patent Office**

**Office européen des brevets**

(19)

(11) Numéro de publication : **0 606 793 B1**

(12)

# FASCICULE DE BREVET EUROPEEN

(45) Date de publication du fascicule du brevet :
**24.05.95 Bulletin 95/21**

(51) Int. Cl.⁶ : **G06F 11/20, G11C 29/00**

(21) Numéro de dépôt : **93403012.3**

(22) Date de dépôt : **14.12.93**

(54) **Procédé de réparation d'éléments défectueux dans une mémoire redondante.**

(30) Priorité : **16.12.92 FR 9215174**

(43) Date de publication de la demande :
**20.07.94 Bulletin 94/29**

(45) Mention de la délivrance du brevet :
**24.05.95 Bulletin 95/21**

(84) Etats contractants désignés :
**DE FR GB IT**

(56) Documents cités :
**EP-A- 0 249 903**
**FR-A- 2 611 400**

(73) Titulaire : **SGS-THOMSON**
**MICROELECTRONICS S.A.**
**7, Avenue Galliéni**
**F-94250 Gentilly (FR)**

(72) Inventeur : **Pignon, Patrick**
**Cabinet BALLOT-SCHMIT,**
**7, rue Le Sueur**
**F-75116 Paris (FR)**

(74) Mandataire : **Schmit, Christian Norbert Marie**
**et al**
**Cabinet Ballot-Schmit**
**7, rue Le Sueur**
**F-75116 Paris (FR)**

EP 0 606 793 B1

## Description

La présente invention concerne un procédé de traitement des éléments défectueux dans une mémoire réalisée en circuit intégré et comportant des éléments de redondance. Elle s'applique plus particulièrement aux testeurs de telles mémoires.

Plus les mémoires ont une grande capacité de stockage d'informations et plus la technologie d'intégration est fine, plus ces mémoires sont sujettes à des défauts de fabrication. Un seul défaut dans une mémoire d'un million de cellules entraîne la mise au rebut de cette mémoire. Or, la tendance de l'industrie est à l'augmentation toujours accrue de la capacité de stockage et à la miniaturisation toujours plus poussée.

Pour augmenter le rendement global de fabrication, des réseaux de mémoire redondants ont été utilisés.

Ainsi, lorsqu'un testeur met en oeuvre les tests sur les tranches de circuit intégré, s'il détecte un ou plusieurs éléments de mémoire défectueux, il va pouvoir les remplacer par des éléments redondants : la mémoire apparaîtra globalement bonne et ne sera pas mise au rebut.

De cette manière, il est possible de récupérer des mémoires comportant un nombre limité de défauts.

On rappelle qu'une mémoire est organisée en une matrice de rangées et de colonnes. A chaque croisement d'une colonne et d'une rangée se trouve une cellule, que l'on peut sélectionner au moyen de l'adresse de la colonne et de l'adresse de la rangée, et dont le contenu est lu sur la colonne.

Les défauts peuvent concerner :
- des cellules de mémoire isolées, par exemple, défauts dans l'oxyde de grille d'une cellule;
- des rangées adjacentes de cellules, par exemple, court-circuit entre deux rangées par des filaments résiduels de silicium polycristallin mal gravé;
- plusieurs rangées de cellules ou plusieurs colonnes, par exemple, par suite d'un mauvais contact à l'intérieur d'un décodeur servant à désigner tout un groupe de rangées, ou tout un groupe de colonnes;
- deux colonnes, par exemple par suite d'un court-circuit par un pont d'aluminium qui relie anormalement deux lignes d'aluminium correspondant à deux colonnes adjacentes,
- etc..

Le testeur d'une mémoire mémorise tous les défauts qui apparaissent lors du test de cette mémoire pour les analyser et déterminer les éléments défectueux.

Il doit ensuite connecter les éléments redondants appropriés en remplacement des éléments défectueux d'une manière telle que l'utilisateur de la mémoire n'ait aucune contrainte particulière due à ce remplacement: on dit que le remplacement doit être transparent pour l'utilisateur qui n'a accès qu'aux bornes extérieures du circuit intégré.

Les éléments redondants seront le plus généralement, pour des mémoires de capacité importante (plusieurs centaines de milliers de bits et au-delà), des rangées entières de cellules plutôt que des cellules individuelles, les rangées étant plus faciles à remplacer, compte-tenu des contraintes d'encombrement des circuits qu'il est nécessaire de rajouter pour que le remplacement soit transparent pour l'utilisateur. Mais certains défauts, comme les courts-circuits par ponts d'aluminium entre deux colonnes, ne peuvent être réparés que par le remplacement de ces colonnes par d'autres colonnes.

Le remplacement d'une colonne est plus difficile que celui d'une rangée. En effet, lorsque la mémoire est organisée en mots de plusieurs bits, une adresse mémoire désigne alors d'une part, une seule rangée déterminée et d'autre part, un nombre de colonnes égal au nombre de bits.

Le remplacement d'une colonne défectueuse peut se faire en aiguillant une colonne redondante à la place d'une colonne défectueuse. Une circuiterie très encombrante est alors nécessaire pour :
- mémoriser l'adresse précise de la colonne défectueuse;
- désactiver la lecture normale des informations provenant de cette colonne;
- lire les informations en provenance d'une colonne redondante;
- ramener ces informations vers l'amplificateur de lecture de la colonne défectueuse.

Il faut prévoir une circuiterie semblable pour l'écriture d'informations dans la colonne redondante.

Une autre solution pour assurer le remplacement d'une colonne défectueuse consiste à prévoir, pour la mémoire organisée par exemple en mots de 8 bits, un groupe de 8 colonnes redondantes destinées à se substituer à un groupe de 8 colonnes dont l'une au moins est défectueuse. Autrement dit, si une adresse de mémoire désigne huit colonnes, et si le testeur détecte un défaut dans l'une au moins de ces huit colonnes, il remplace tout le groupe de huit colonnes désigné par cette adresse par un groupe de huit colonnes redondantes.

D'autres solutions sont possibles et le choix de l'une ou l'autre dépend de la structure de la mémoire, des contraintes d'encombrement de la circuiterie nécessaire et de la capacité de réparation désirée.

Dans la suite, on désigne par élément défectueux d'une mémoire donnée la plus petite structure de rangées ou de colonnes de cette mémoire qui est réparable par un élément redondant de même structure de rangées ou de colonnes.

Ce peut donc être une seule rangée ou colonne, ou un ensemble de lignes ou colonnes dont l'une au moins est défectueuse.

On notera que certaines mémoires ne mettent en oeuvre qu'un seul type de redondance, par exemple, la redondance sur les colonnes.

C'est le testeur, lorsqu'il a pu établir une liste des éléments défectueux d'une mémoire donnée, qui met en oeuvre la réparation de cette mémoire : il remplace chaque élément défectueux par un élément redondant.

D'une manière générale, il inscrit dans des éléments de mémorisation de la mémoire, une information identifiant l'élément défectueux et une information identifiant l'élément redondant qui le remplace.

Ces éléments de mémorisation peuvent être un réseau mémoire ou une batterie de fusibles et constituent la table d'activation de redondance de la mémoire.

C'est cette table qui permet, lors du fonctionnement ultérieur de la mémoire, de sélectionner l'élément de redondance correspondant à un élément défectueux dont l'adresse est présentée en entrée sur la mémoire.

Après chaque réparation d'un élément défectueux, le testeur applique le test de détection de défaut sur cet élément défectueux réparé. Ce test consiste principalement à vérifier qu'une information lue est bien celle qui a été précédemment écrite. Si le test est positif, la mémoire est bonne, s'il est négatif, c'est-à-dire si au moins un défaut est trouvé, la mémoire est mise au rebut. Il n'est en effet pas possible de réparer un élément défectueux déjà réparé, c'est-à-dire déjà remplacé par un élément de redondance: la réparation est en général irréversible.

En outre, il est en général préféré de réparer d'abord les éléments colonnes avant les éléments rangées. Ce sont en effet ces éléments colonnes qui, statistiquement, produisent le plus grand nombre de défauts.

Or, à supposer qu'une rangée soit fortement défectueuse, les colonnes défectueuses étant réparées en premier, il est fortement probable que les colonnes réparées apparaissent toujours défectueuses et la mémoire sera mise au rebut, alors que les défauts détectés sur des colonnes réparées peuvent provenir de la ligne fortement défectueuse non encore réparée.

En effet, on rappelle que les colonnes redondantes sont placées sur la continuation des rangées du plan mémoire, et les rangées redondantes sur les colonnes du plan mémoire.

L'invention a pour objet un procédé de réparation qui permet de n'effectuer le remplacement d'un élément défectueux que lorsque l'on peut être pratiquement certain que la réparation elle-même ne sera pas défectueuse. Selon l'invention, on augmente la probabilité de réussite de réparation, tout en diminuant le temps consacré à la réparation lorsque celle-ci est en fait impossible.

En effet, le test de détection de défauts dans une mémoire ne portent que sur les éléments opérationnels de cette mémoire. Les réseaux de redondance ne sont pas testés. Or, ils peuvent également présenter des défauts semblables à ceux cités précédemment.

Selon l'invention, le testeur teste les éléments redondants pour effectuer une première opération d'attribution ou d'appariement d'un élément redondant avec un élément défectueux. Lorsque tous les éléments défectueux ont pu être appariés, on effectue le remplacement en mémoire, en remplissant la table de redondance. Ensuite, les éléments réparés sont testés.

Telle qu'elle est revendiquée dans la revendication 1, l'invention concerne un procédé de réparation d'éléments défectueux d'une mémoire comportant des éléments redondants. Le préambule de la revendication 1 est connu du document FR-A-2 611 400.

Selon l'invention, le procédé de réparation comporte les étapes suivantes pour un testeur:

1) Pour chaque élément défectueux détecté,
- recherche d'un premier élément redondant non défectueux par test des éléments redondants de la mémoire;
- attribution de ce premier élément redondant à l'élément défectueux, ledit procédé étant caractérisé en ce qu'il comporte l'étape suivante:

2) Quand le testeur a pu attribuer un élément redondant à chaque élément défectueux, remplacement dans la mémoire de chaque élément défectueux par l'élément redondant attribué, par l'inscription dans une table de correspondance, contenue dans un circuit de redondance ($R_C$, $R_L$), des éléments défectueux, et pour chacun d'eux, de l'identification de l'élément redondant le remplaçant, au moyen de signaux de contrôle ($t_l$, $t_c$).

Avantageusement, le test effectué sur les éléments redondants est un test rapide permettant de déceler les défauts importants. De préférence, il s'agira d'un test de lecture.

Il est en effet toujours important de ne pas trop augmenter les temps de test tout en recherchant une fiabilité optimum, le coût des procédures de test étant toujours trop élevé. Ainsi, selon l'invention, les éléments redondants présentant un défaut en lecture sont écartés de la réparation. Les éléments défectueux sont ensuite réparés avec des éléments redondants testés. Avantageusement, ce n'est qu'une fois que tous les éléments défectueux sont réparés, que la réparation est elle-même testée.

D'autres caractéristiques et avantages de l'invention sont détaillées dans la description non limitative qui suit, faite en référence aux dessins annexés dans lesquels:
- la figure 1 représente un schéma de principe d'une mémoire avec un système de redondance de rangées et de colonnes et,
- la figure 2 est un organigramme du procédé de réparation selon l'invention.

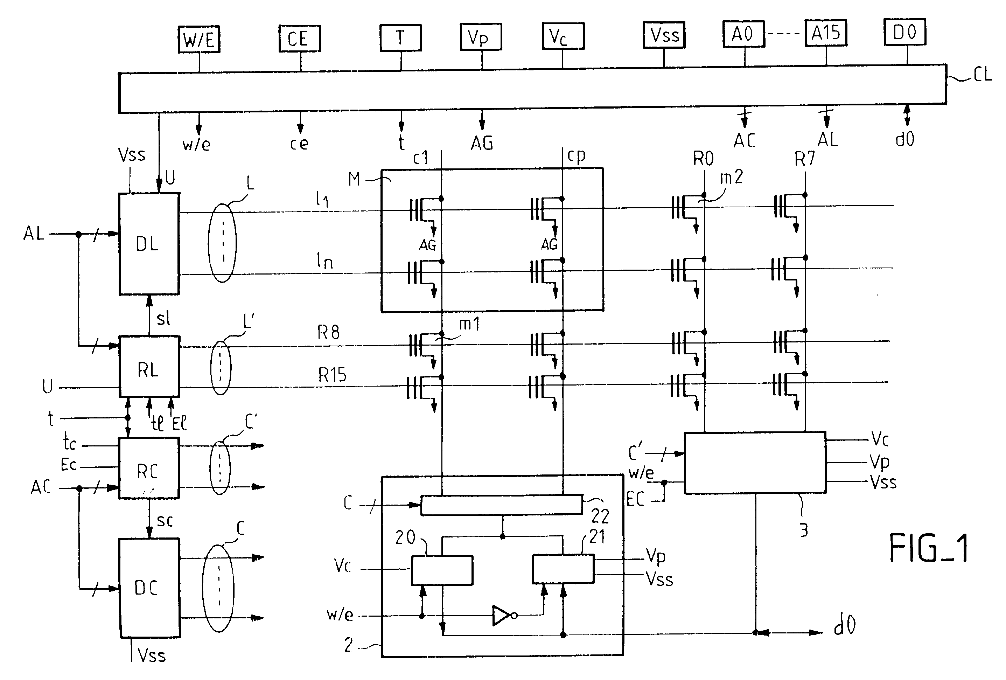

La figure 1 représente schématiquement une structure de mémoire à redondance de rangées et de colonnes.

Pour la clarté de l'exposé, le cas simple d'une mémoire organisée en mots de un seul bit a été représenté. Le plot correspondant d'entrée/sortie de la mémoire est noté D0.

Le plan mémoire M comprend n rangées l1 à ln de p cellules et p colonnes c1 à cp de n cellules. D'une manière connue, sur une rangée, les grilles des p cellules sont réunies ensemble et sur une colonne, les drains des n cellules sont réunis ensemble. Les sources des cellules du plan mémoire sont réunies en commun à un potentiel AG commandé par un circuit logique CL du circuit. En général, ce potentiel est la masse. Dans certain cas, il correspond à une haute tension (par exemple, pour l'effacement d'une mémoire flash EPROM).

Une adresse d'un mot du plan mémoire est codée dans l'exemple sur 16 bits d'adresse A0-A15 et elle se décompose en une adresse de rangée AL et une adresse de colonne AC. Dans l'exemple où ce mot comporte un seul bit, l'adresse désigne une seule cellule du plan mémoire.

Un circuit logique CL de commande est connecté aux broches ou plots de la mémoire. Classiquement il reçoit ainsi un signal de sélection de la mémoire CE, un signal de commande de lecture/écriture W/E, un signal de mode de test T, les tensions d'alimentation Vc, de programmation Vp, de masse Vss, les signaux d'entrées/sorties de données réduits dans l'exemple au seul signal D0, et les signaux d'adresse A0-A15. Selon le type de mémoire envisagé, la tension de programmation peut être une haute tension de l'ordre de 12 volts ou égale à la tension d'alimentation Vc.

Le circuit logique CL délivre en sortie, un signal U de commande des rangées, les recopies w/e, d0, ce, t des signaux W/E, D0, CE, T, les signaux d'alimentation et les signaux d'adresse AL de rangée et AC de colonne.

Un décodeur de rangée DL reçoit en entrée l'adresse de rangée AL, le signal de commande en tension U, la masse Vss et un signal d'invalidation sl. Ce signal sl est activé par un circuit de redondance de rangées RL, lorsque ce dernier a reconnu une adresse de rangée défectueuse et que la redondance doit alors être activée.

Le décodeur de rangée, s'il n'est pas invalidé par le signal sl, délivre une sortie L à n composantes (une par rangée) qui sélectionne la rangée parmi les n rangées correspondant à l'adresse AL en appliquant sur cette rangée le signal de commande en tension U.

La sortie L porte les autres rangées en général à la masse Vss.

La commande en tension U dépend de l'opération à effectuer sur la rangée : lecture, écriture d'un "0" logique ou écriture d'un "1" logique. Elle peut être égale à Vc, Vp ou Vss. On rappelle que la tension à appliquer dépend du type de mémoire envisagé (EEPROM, EPROM, flash EPROM, RAM...). On rappelle aussi que dans le cas d'une mémoire de type EPROM, un niveau logique, "0" par exemple, est écrit électriquement, mais l'autre, "1", est obtenu par effacement ultra-violet. Pour une mémoire EEPROM ou flash EPROM, l'écriture d'un "1" et d'un "0" se font électriquement.

Si le décodeur de rangée DL est invalidé par le signal sl, il maintient sa sortie L à la masse Vss du circuit.

Le circuit de redondance de rangées RL reçoit en entrée l'adresse de rangée AL, la commande en tension U, la masse Vss, le signal de mode de test t, un signal de lecture/écriture El et un signal de contrôle tl.

En fonctionnement normal (t=o), il délivre un signal d'invalidation sl vers le décodeur de rangée et une sortie L' à m composantes pour activer une rangée de redondance d'un réseau de m rangées redondantes, où m=8 dans l'exemple (rangées R8 à R15).

La rangée à activer est indiquée dans une table de correspondance du circuit RL, qui contient des adresses de rangées défectueuses et pour chacune, l'adresse ou l'identification de la rangée redondante qui la remplace. Cette table est en général une mémoire comprenant une zone mémoire non effaçable par élément redondant pour y inscrire une adresse d'élément défectueux.

Le circuit RL effectue une comparaison entre l'adresse AL et ces adresses défectueuses. Le cas échéant, sa sortie sl désactive le décodeur de rangée DL et il délivre une sortie L' qui sélectionne la rangée redondante correspondant à l'adresse AL et lui applique la commande en tension U.

Un décodeur de colonne DC reçoit en entrée l'adresse de colonne AC un signal d'invalidation sc et les niveaux logiques de tension Vc et Vss. S'il n'est pas invalidé par le signal sc, il délivre une sortie logique C à p composantes (une par colonne) qui sélectionne la colonne parmi p correspondant à l'adresse AC. (colonne sélectionnée à Vc, les autres colonnes à la masse Vss).

Cette sortie logique C permet d'aiguiller la colonne adressée sur l'entrée/sortie d0 et d'appliquer sur cette colonne un niveau de tension déterminé selon l'opération à effectuer : lecture, écriture d'un "1" ou d'un "0".

L'aiguillage en sortie est réalisé par un circuit 2 de commande d'entrée/sortie comprenant un circuit d'aiguillage 22, une interface de sortie 20 et une interface d'entrée 21. Ce circuit 2 reçoit en entrée le signal d'écriture/lecture w/e, la sortie logique C et les différents niveaux de tension Vc, Vp, Vss. Il est par ailleurs relié au signal d0 d'entrée/sortie de données.

Si une commande de lecture (w/e=0) est présentée, l'interface 20 est validée. Si une commande d'écriture (w/e=1) est présentée, l'interface 21 est validée.

Le circuit 22 connecte la colonne désignée par la sortie logique C sur les interfaces d'entrée/sortie 20,21.

Le niveau de tension correspondant à la commande de lecture/écriture w/e est appliqué sur la colonne désignée par la sortie C du décodeur de colonne DC, par l'interface correspondante 20 ou 21 sélectionnée. Par exemple, pour une commande de lecture, l'interface 20 applique une tension de lecture sur cette colonne aiguillée par le circuit 22. Pour une mémoire EPROM, cette tension de lecture est de l'ordre de 1 volt. Pour une mémoire RAM, elle est généralement égale à Vss. Dans le cas d'une commande d'écriture, le circuit 21 applique la tension Vss ou une tension de l'ordre de Vp/2 sur cette colonne, en fonction de la donnée à écrire "1" ou "0".

On rappelle ici que les niveaux de tension applicables dépendent aussi des technologies et du type de mémoire utilisé.

Si le circuit décodeur de colonne DC est invalidé par le signal sc, il maintient sa sortie C à la masse Vss du circuit.

Le circuit de redondance de colonnes RC reçoit en entrée l'adresse de colonne AC, le signal de mode de test t, un signal de lecture/écriture Ec et un signal de contrôle tc.

Dans l'exemple, le réseau de colonnes redondantes associé comprend r=8 colonnes de redondance R0 à R7.

Le circuit de redondance RC contient dans une table de correspondance des adresses de colonnes défectueuses et pour chacune l'adresse ou l'identification de la colonne redondante qui la remplace. Cette table est en général une mémoire comprenant une zone mémoire non effaçable par élément redondant pour y inscrire une adresse d'élément défectueux.

En fonctionnement normal (t=0), il effectue une comparaison entre l'adresse AC et ces adresses défectueuses contenues dans la table de correspondance. Le cas échéant, il délivre un signal d'invalidation sc vers le décodeur de colonne DC et une sortie C' à r composantes pour sélectionner la colonne redondante désignée dans la table.

Cette sortie C' est appliquée à un circuit 3 de commande d'entrée/sortie des colonnes de redondance.

Le circuit de commande d'entrée/sortie 3 est semblable au circuit 2. Il reçoit en entrée le signal d'écriture/lecture w/e, le signal Ec, la sortie logique C' et les différents niveaux de tension Vc, Vp, Vss. Il est par ailleurs relié au signal d0 d'entrée/sortie de données.

Le circuit 3 permet de relier la colonne de redondance désignée par le signal C' au plot d'entrée/sortie D0 par une interface d'entrée pour une commande d'écriture (w/e=1) ou par une interface de sortie pour une commande de lecture (w/e=0) et de lui appliquer le niveau de tension requis.

En mode de test t=1, un testeur sur tranches peut appliquer d'autres signaux de commande en différents points de test.

C'est le cas en particulier des signaux de lecture/écriture El et Ec et des signaux de contrôles tl et tc appliqués aux circuits de redondance RL, RC et 3.

En ce qui concerne les signaux de lecture/écriture El et Ec, il permettent en mode de test (t=1) d'accéder directement aux différentes cellules de redondance en écriture ou en lecture.

Cet accès se fait tantôt par sélection d'une rangée redondante et d'une colonne du plan mémoire (cellule m1), tantôt d'une rangée redondante et d'une colonne redondante (cellule m2), tantôt d'une rangée du plan mémoire et d'une colonne redondante.

Par exemple, pour sélectionner en écriture la cellule redondante notée m1 sur la figure 1, on présente l'adresse de la rangée redondante R8 sur AL tout en activant le signal El en écriture. Simultanément, l'adresse de la colonne c1 du plan mémoire est présentée sur AC et le signal w/e est activé en écriture.

Pour sélectionner en lecture la cellule mémoire redondante notée m2 sur la figure 1, on présente l'adresse de la rangée l1 du plan mémoire sur AL tout en activant en lecture le signal w/e. Simultanément, on présente l'adresse de la colonne redondante R0 sur AC et on active en lecture le signal Ec.

En ce qui concerne les signaux de contrôle tl et tc, ils permettent en mode de test (t=1), d'écrire ou de remplir la table de correspondance de la redondance associée, c'est à dire d'effectuer la réparation de la mémoire.

Par exemple, pour remplir la table de correspondance de la redondance colonne :

- on active le mode de test (t=1)
- on active le signal de contrôle de la redondance colonne (tc=1)
- on présente sur l'adresse AC, l'adresse de la zone mémoire de la colonne redondante à sélectionner dans la table de correspondance, suivie de l'adresse de la colonne défectueuse qu'elle remplace.
La table est donc de la forme :

| adresse table | colonne redondante | adresse colonne défectueuse AC |
|---|---|---|
| 0 | R0 | 5 |
| 1 | R1 | 12 |
| 2 | R2 | 124 |
| 3 | R3 | / |
| 4 | R4 | / |
| 5 | R5 | / |
| 6 | R6 | / |
| 7 | R7 | - / |

La table de correspondance de redondance rangée est remplie de manière identique au moyen de l'adresse AL et des signaux t et tl.

Nous venons de décrire une mémoire dont la structure permet l'activation de la redondance de rangées et de colonnes, avec remplissage par le testeur de tables de correspondance et avec possibilité d'accès direct en lecture/écriture aux éléments redondants. Différentes structures mémoires sont possibles qui permettent ces mêmes fonctions, notamment les structures de mémoires volatiles (RAM).

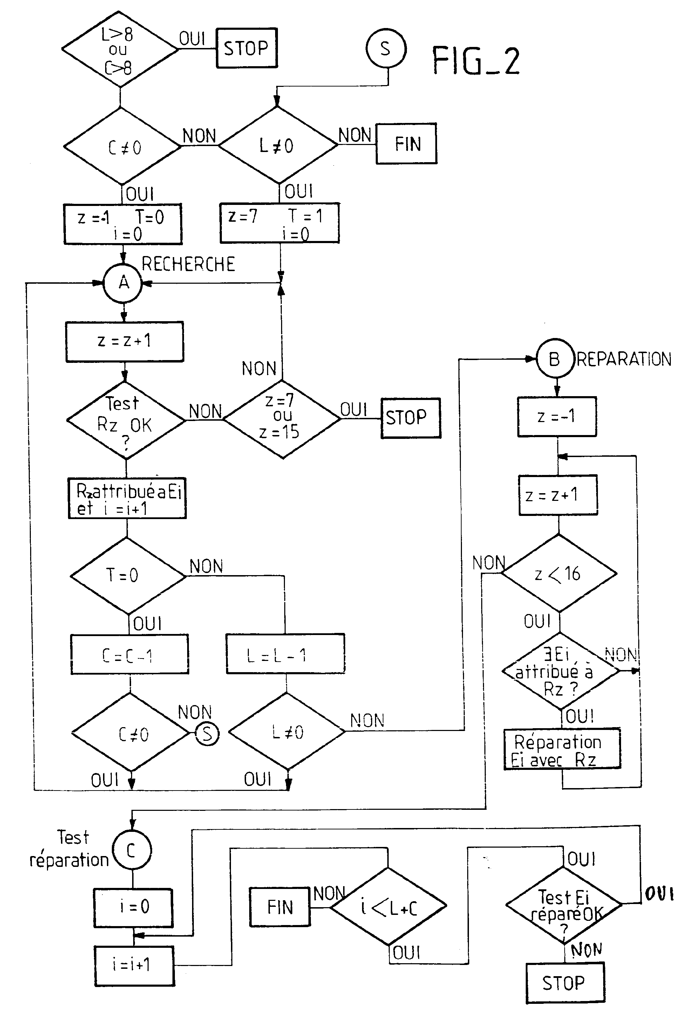

Le procédé de réparation selon l'invention, s'applique à toutes ces mémoires. Il va être décrit en référence aux figures 1 et 2, le testeur sur tranches ayant déjà effectué le test de détection de défaut sur le plan mémoire et établi une liste d'éléments défectueux Ei, où i=(1,...L+C), L étant le nombre de rangées défectueuses et C étant le nombre de colonnes défectueuses. Dans l'exemple de structure mémoire de la figure 1, un élément défectueux est une colonne ou une rangée de la mémoire.

Tout d'abord le procédé de réparation ne peut être mis en oeuvre s'il n'y a pas assez d'éléments redondants dans chaque classe. Dans l'exemple où on a m=8 rangées redondantes et r=8 colonnes redondantes, il faut vérifier que L est inférieur ou égal à 8 et que C est inférieur ou égal à 8. Si tel n'est pas le cas, le plan mémoire est irréparable et la mémoire est mise au rebut. C'est l'étape STOP dans l'organigramme. Si la mémoire est réparable, on met en oeuvre le procédé de réparation.

Selon l'invention, il comprend essentiellement deux étapes :
- une étape de recherche A et
- une étape de réparation B.

L'étape de recherche A consiste, pour chaque élément défectueux Ei, à rechercher le premier élément redondant dont un test va donner un résultat positif.

L'objet de la recherche est d'écarter les éléments redondants qui présentent des défauts importants repérables facilement, pour ne pas trop allonger la procédure de réparation. On se contentera de préférence d'un test simple de lecture aux tensions nominales de la mémoire. Comme les éléments redondants sont des rangées ou des colonnes, le test consiste par exemple sur une rangée redondante, à sélectionner cette rangée, et à sélectionner chacune des colonnes séparément ou encore simultanément par groupes, selon les possibilités offertes par la mémoire, et à aller lire la ou les cellules sélectionnées. Dans ce cas, l'état lu correspond à un état vierge des cellules redondantes, qui selon les technologies correspond à un état effacé ou programmé. On rappelle qu'une cellule est vierge quand elle n'a jamais été écrite. C'est notamment le cas en sortie de fabrication, au moment du test.

Il est aussi possible de réaliser un test d'écriture/lecture, si l'écriture de la mémoire n'est pas une opération trop délicate, notamment si elle ne met pas en oeuvre de hautes tensions.

De préférence, on commence par traiter les colonnes et ensuite les rangées. On a pu en effet constater que les colonnes sont en général le siège de plus de défauts. On a donc numéroté les éléments défectueux Ei de la manière suivante :
- colonnes défectueuses : E1 à EC
- lignes défectueuses: EC+1 à EC+L
et les éléments redondants Rz :

- colonnes redondantes de R0 à R7
- lignes redondantes R8 à R15.

Avec une telle numérotation, l'étape de recherche traite donc en premier lieu les colonnes. Elle prend le premier élément défectueux E0, puis recherche le premier élément redondant Rz, non défectueux en commençant par R0.

Elle l'attribue alors à E0.

Elle prend l'élément défectueux suivant E1 et le premier élément redondant non défectueux, en commençant par l'élément redondant qui suit celui qui vient d'être attribué et ainsi de suite.

Si il y a beaucoup d'éléments redondants défectueux parmi R0...R7, il ne va pas être possible d'attribuer un élément redondant à tous les éléments défectueux E1 à EC: la mémoire est irréparable. C'est l'étape STOP.

Si tous les éléments défectueux E1 à EC ont pu se faire attribuer un élément redondant non défectueux parmi R0...R7, on passe au traitement des rangées. Ou bien on peut attribuer un élément redondant parmi R8...R15 qui a été testé positivement à chaque élément défectueux EC+1...EC+L ou bien on ne peut pas. Dans ce dernier cas, la mémoire est mise au rebut. Sinon, on passe à l'étape de réparation.

On remarquera que le fait de traiter les colonnes en premier lieu optimise le temps de test. En effet s'il y a peu de défauts sur les colonnes redondantes, l'expérience montre, qu'il en sera probablement de même sur les rangées. Au contraire, si la mémoire est plutôt défectueuse, il est probable que beaucoup de colonnes seront défectueuses et le procédé de réparation s'arrêtera très tôt.

L'étape de réparation B consiste pour le testeur à remplir les tables de correspondance rangées et colonnes de la mémoire, avec les couples élément défectueux, élément redondant, qu'il a constitué à l'étape A.

On remarquera donc que l'on ne passe à cette étape, qu'une fois que l'on a pu passer correctement l'étape de recherche/attribution.

L'étape de réparation consiste alors pour le testeur à prendre chacun des éléments redondants qu'il a apparié avec un élément défectueux et à remplir la table de correspondance associée en conséquence. Lorsqu'il a traité tous les éléments colonnes et rangées, la mémoire est réparée.

Avantageusement, le testeur reprend le test de détection du plan mémoire, qu'il applique sur les éléments défectueux réparés. Il vérifie ainsi que la redondance fonctionne correctement. En effet à l'étape A, on accède directement aux éléments redondants. On ne teste donc pas tous les circuits utilisés en redondance, les circuits d'aiguillage notamment. Ici, on effectue un test complet des éléments réparés. C'est l'étape notée C sur la figure 2. On teste donc tous les éléments de circuit activés en redondance. Ce test consiste à effectuer une écriture/lecture d'une donnée et de sa donnée complémentaire en adressant l'élément défectueux, comme le ferait un utilisateur. La lecture est de préférence effectuée avec une tension d'alimentation Vc que l'on fait varier dans la plage de fonctionnement spécifiée dans le cahier des charges. Par exemple entre 4 et 6 volts.

La mémoire est alors complètement qualifiée. Extérieurement, rien ne la distingue d'une mémoire sans défaut.

Le procédé de l'invention permet d'améliorer la fiabilité de la réparation : quand on a réalisé l'étape A avec succès, en pratique on peut être pratiquement certain que la mémoire sera bonne après l'étape B de réparation. Il n'y a pas de risque de sortir du processus de réparation à cause d'un élément non réparé qui fait apparaître un élément réparé comme défectueux.

Le procédé de réparation selon l'invention est très efficace, car on élimine tout suite les causes d'échec majeures de la réparation. Ce procédé s'applique aux différentes structures de redondance et de mémoire. Notamment lorsque le plan mémoire est organisé en mots de g bits avec n lignes et g ensembles de p colonnes, chaque ensemble étant associé à r colonnes de redondance, un élément défectueux peut être, dans certaines structures, constitué des g colonnes d'un mot mémoire, chacune ayant le même rang h parmi p colonnes dans chaque ensemble, et dont l'une au moins est défectueuse. Un élément redondant sera alors constitué de g colonnes de redondance, une dans chaque ensemble et chacune de même rang j parmi r colonnes de redondance. Le test pour la recherche et l'attribution est alors effectué sur les g colonnes de redondance.

Si l'élément défectueux est constitué d'une colonne de rang h parmi p dans un seul ensemble, la colonne redondante sera prise parmi les r colonnes redondantes associées à cet ensemble. Et c'est cette colonne redondante qui sera testée.

Dans tous les types de structure, une rangée défectueuse sera en général remplacée par une rangée redondante.

## Revendications

1. Procédé de réparation d'éléments défectueux d'un plan mémoire (M) dans un circuit mémoire comportant en outre des éléments mémoire redondants (R0-R15), le plan mémoire ayant subi un test de détection d'éléments défectueux (Ei), ledit procédé de réparation comportant les étapes suivantes pour un testeur :

A) Pour chaque élément défectueux détecté (Ei),
- recherche du premier élément redondant (Rz) non défectueux par test des éléments redondants;
- attribution de ce premier élément redondant à l'élément défectueux;

ledit procédé étant caractérisé en ce qu'il comporte l'étape suivante :

B) Quand un élément redondant a pu être attribué à chaque élément défectueux, remplacement de chaque élément défectueux par l'élément redondant attribué, par l'inscription dans une table de correspondance, contenue dans un circuit de redondance ($R_C$, $R_L$), des éléments défectueux, et pour chacun d'eux, de l'identification de l'élément redondant le remplaçant, au moyen de signaux de contrôle ($t_l$, $t_c$).

2. Procédé selon la revendication 1, caractérisé en ce que l'on soumet les éléments défectueux réparés au test de détection d'éléments défectueux.

3. Procédé selon la revendication 1 ou 2, le plan mémoire étant organisé en n lignes et g ensembles de p colonnes, chaque ensemble étant associé à r colonnes de redondance, caractérisé en ce que pour un élément défectueux constitué de g colonnes, une de même rang h parmi p rang de colonnes dans chaque ensemble, l'une au moins des g colonnes étant défectueuse, un élément redondant est constitué de g colonnes de redondance, une de même rang j parmi r colonnes de redondance dans chaque ensemble, le test d'un élément redondant étant effectué sur ses g colonnes de redondance.

4. Procédé selon la revendication 1 ou 2, le plan mémoire étant organisé en n lignes et g ensembles de p colonnes, chaque ensemble étant associé à r colonnes de redondance, caractérisé en ce que pour un élément défectueux constitué par une colonne défectueuse de rang h parmi les p colonnes d'un ensemble, un élément redondant pour remplacer cet élément défectueux est une colonne de redondance de rang j parmi r de ce même ensemble.

5. Procédé selon l'une quelconque des revendications précédentes, le plan mémoire étant organisé en n lignes et g ensembles de p colonnes et associé à m lignes de redondance, caractérisé en ce que pour un élément défectueux constitué par une ligne défectueuse parmi n, un élément redondant est constitué par une ligne de redondance parmi m.

6. Procédé selon l'une quelconque des revendications précédentes, les éléments redundants étant vierges, caractérisé en ce que le test d'un élément redondant (Rz) consiste à lire cet élément pour vérifier que la donnée lue correspond à cet état vierge.

7. Procédé selon l'une quelconque des revendications précédentes, caractérisé en ce que le test d'un élément redondant (Rz) consiste :
- à programmer une donnée dans cet élément;
- à lire cet élément pour vérifier que cette donnée est bien programmée.

8. Procédé selon la revendication 6 ou 7, caractérisé en ce que la lecture se fait en appliquant une tension nominale d'alimentation au circuit mémoire.

9. Procédé selon l'une quelconque des revendications précédentes, caractérisé en ce que le test de détection sur un élément défectueux réparé consiste :
- à programmer une donnée dans cet élément;
- à lire cette donnée en faisant varier la tension d'alimentation appliquée au circuit mémoire dans une plage de valeurs autorisée.

10. Procédé selon la revendication 8, caractérisé en ce que l'on recommence ce test avec la donnée complémentaire.

**Claims**

1. Method of repairing defective elements in a memory plane (M) in a memory circuit also including redundant memory elements (R0-R15), the memory plane having undergone a test for detecting defective elements (Ei), the said repair method including the following steps for a tester:

A) for each defective element detected (Ei),
- seeking the first non-defective redundant element (Rz) by testing the redundant elements;
- allocating this first redundant element to the defective element;
the said method being characterised in that it includes the following step:

B) when it has been possible to allocate a redundant element to each defective element, replacing each defective element with the allocated redundant element, entering the defective elements in a correspondence table contained in a redundant circuit ($R_C$, $R_L$) and, for each of them, identifying the redundant element replacing it by means of check signals ($t_i$, $t_c$).

2. Method according to Claim 1, characterised in that the repaired defective elements are subjected to the defective element detection test.

3. Method according to Claim 1 or 2, the memory plane being organised in n rows and g sets of p columns, each set being associated with r redundant columns, characterised in that, for a defective element consisting of g columns, one of the same rank h amongst p ranks of columns in each set, at least one of the g columns being defective, a redundant element consists of g redundant columns, one of the same rank j amongst r redundant columns in each set, the testing of a redundant element being carried out on its g redundant columns.

4. Method according to Claim 1 or 2, the memory plane being organised in n rows and g sets of p columns, each set being associated with r redundant columns, characterised in that, for a defective element consisting of a defective column of rank h amongst the p columns of a set, a redundant element for replacing this defective element is a redundant column of rank j amongst r of this same set.

5. Method according to any one of the preceding claims, the memory plane being organised in n rows and g sets of p columns and associated with m redundant rows, characterised in that, for a defective element consisting of one defective row amongst n, a redundant element consists of one redundant row amongst m.

6. Method according to any one of the preceding claims, the redundant elements being blank, characterised in that the testing of a redundant element (Rz) consists of reading this element to check that the data read corresponds to this blank state.

7. Method according to any one of the preceding claims, characterised in that the testing of a redundant element (Rz) consists of:
- programming a data item in this element;
- reading this element to check that this data has indeed been programmed.

8. Method according to Claim 6 or 7, characterised in that the reading is carried out by applying a nominal supply voltage to the memory circuit.

9. Method according to any one of the preceding claims, characterised in that the detection test on a repaired defective element consists of:
- programming a data item in this element;
- reading this data whilst varying the supply voltage applied to the memory circuit within a permitted range of values.

10. Method according to Claim 8, characterised in that this test is recommenced with the complementary data item.


**Patentansprüche**

1. Verfahren zur Reparatur defekter Elemente einer Speicheranordnung (M) in einer ferner redundante Speicherelemente (R0-R15) umfassenden Speicherschaltung, bei dem die Speicheranordnung einer Prüfung zur Erfassung defekter Elemente (Ei) unterzogen wird, wobei das Reparaturverfahren die folgenden Schritte für eine Prüfeinrichtung umfaßt:

A) Für jedes erfaßte defekte Element (Ei)
- Suchen des ersten, nicht defekten redundanten Elements (Rz) durch Prüfen der redundanten Elemente;
- Zuweisen dieses ersten redundanten Elements an das defekte Element; wobei
das Verfahren dadurch gekennzeichnet ist, daß es den folgenden Schritt umfaßt:

B) Ersetzen, wenn jedem defekten Element ein redundantes Element zugewiesen werden konnte, jedes defekten Elements durch das zugewiesene redundante Element durch Eintragen, mittels Steuersignalen ($t_l$, $t_c$), in eine in einer Redundanzschaltung ($R_C$, $R_L$) enthaltene Tabelle für die Zuordnung defekter Elemente sowie, für jedes derselben, die Erkennung des dieses ersetzenden redundanten Elements.

2. Verfahren nach Anspruch 1, dadurch gekennzeichnet, daß die defekten reparierten Zellen der Prüfung zur Erfassung defekter Elemente unterzogen werden.

3. Verfahren nach Anspruch 1 oder 2, wobei die Speicheranordnung in n Zeilen und g Gruppen von p Spalten organisiert und jede Gruppe r Redundanzspalten zugeordnet ist, dadurch gekennzeichnet, daß für ein defektes Element, welches aus g Spalten besteht, von denen zumindest eine der g Spalten mit gleicher Wertigkeit h unter p Spaltenwertigkeiten in jeder Gruppe defekt ist, ein redundantes Element aus g Redundanzspalten besteht, eine mit gleicher Wertigkeit j unter r Redundanzspalten in jeder Gruppe, wobei die Prüfung eines redundanten Elements über seine g Redundanzspalten ausgeführt wird.

4. Verfahren nach Anspruch 1 oder 2, wobei die Speicheranordnung in n Zeilen und g Gruppen von p Spalten organisiert und jede Gruppe r Redundanzspalten zugeordnet ist, dadurch gekennzeichnet, daß für ein durch eine defekte Spalte der Wertigkeit h unter den p Spalten einer Gruppe gebildetes defektes Element ein redundantes Element zum Ersetzen dieses defekten Elements eine Redundanzspalte der Wertigkeit j aus r dieser einzelnen Gruppe ist.

5. Verfahren nach einem beliebigen der vorhergehenden Ansprüche, wobei die Speicheranordnung in n Zeilen und g Gruppen von p Spalten organisiert und m Redundanzzeilen zugeordnet ist, dadurch gekennzeichnet, daß für ein durch eine defekte aus n Zeilen gebildetes defektes Element ein redundantes Element durch eine Redundanzzeile aus m gebildet wird.

6. Verfahren nach einem beliebigen der vorhergehenden Ansprüche, wobei die redundanten Elemente ursprünglich sind, dadurch gekennzeichnet, daß die Prüfung eines redundanten Elements (Rz) im Lesen dieses Elements zum Verifizieren, daß das gelesene Datum diesem ursprünglichen Zustand entspricht, besteht.

7. Verfahren nach einem beliebigen der vorhergehenden Ansprüche, dadurch gekennzeichnet, daß die Prüfung eines redundanten Elements (Rz) aus
- dem Einprogrammieren eines Datums in dieses Element; und
- dem Lesen dieses Elements zum Verifizieren, daß dieses Datum richtig eingespeichert ist,
besteht.

8. Verfahren nach Anspruch 6 oder 7, dadurch gekennzeichnet, daß das Lesen durch Anlegen einer Nenn-Speisespannung an die Speicherschaltung erfolgt.

9. Verfahren nach einem beliebigen der vorhergehenden Ansprüche, dadurch gekennzeichnet, daß die Prüfung zur Erfassung für ein defektes, repariertes Element aus
- dem Einprogammieren eines Datums in dieses Element; und
- dem Lesen dieses Datums durch Variieren der an die Speicherschaltung angelegten Speisespannung innerhalb eines zulassigen Wertebereichs besteht.

10. Verfahren nach Anspruch 8, dadurch gekennzeichnet, daß dieser Test mit dem komplementären Datum neu begonnen wird.

FIG_1

EP 0 606 793 B1

FIG_2